# EUROPÄISCHE PATENTSCHRIFT

(11) **EP 0 354 380 B1**
(45) Veröffentlichungstag und Bekanntmachung des Hinweises auf die Patenterteilung: **02.02.1994**
(21) Anmeldenummer: 89112929.8
(22) Anmeldetag: 14.07.1989
(51) Int. Cl.: H01L 31/18

(54) **Verfahren zur Herstellung eines flexiblen Trägersubstrates**
Method of producing a flexible substrate
Procédé de fabrication d'un substrat flexible

(30) Priorität: 12.08.1988 DE 3827433
(43) Veröffentlichungstag der Anmeldung: 14.02.1990
(73) Patentinhaber: Deutsche Aerospace AG, 81663 München (DE)
(72) Erfinder: Maass, Heinz, D-2000 Hamburg 61 (DE)
(74) Vertreter: Schulze, Harald Rudolf, Dipl.-Ing.

(56) Entgegenhaltungen:
- DE-A- 2 160 345
- DE-A- 2 541 536
- US-A- 4 755 231

## Beschreibung

Die Erfindung betrifft ein Verfahren gemäß dem Oberbegriff von Anspruch 1.

Es ist ein flexibler Solargenerator mit einer Vielzahl von auf einem aufrollbaren Substrat angeordneten fotoelektrischen Solarzellen, die mittels aus gewalztem Material ausgestanzter Verbinder in Parallel- und Reihenverschaltung untereinander elektrisch leitend verbunden sind, bekannt (DE-PS 21 60 345). Die Rollrichtung zeigt in die Richtung der Parallelverschaltung, wobei jeweils getrennte Verbinder für die Parallel- und für die Reihenverschaltung vorgesehen sind. Die Verbinder sind in der Weise ausgebildet, daß die Walsrichtung des Materials jeweils in die Richtung der Verschaltung zeigt.

Die erforderliche Festigkeit dieser fexiblen Solargeneratoranlage wird bezüglich des Trägermaterial dadurch erreicht, daß das als Träger dienende aufrollbare Substrat aus einer mit Glasseide beklebten Polymidfolie besteht. Als Kleber sind dabei einige für Weltraumbedingungen geeignete, d. h. beispielsweise bis 10-12 Torr und im Temperaturbereich von - 180 bis + 100° C beständige dünnflüssige Kleber gewählt worden, z. B. stark lösungsmittelhaltige Polyester-Kleber, mit denen eine gute Benetzung des Glasseidengewebes und gute Verklebungen des Gewebes mit der Polyimidfolie erreicht werden. Die Beklebung der Polyimidfolie mit der Glasseidenlage erfolgt dabei in der Weise, daß zunächst die Glasseidenlage auf die Polyimidfolie gelegt wird und anschließend der Kleber in einer sehr dünnen Schicht aufgetragen wird. Nach dem Aushärten des Klebers ergibt sich ein weiterhin ausreichend flexibles, jedoch in seinen Festigkeitseigenschaften erheblich verbessertes Substrat. An Stelle der obengenannten Kleber können für Temperaturbereiche von -60 bis + 260° C lösungsmittelhaltige Silikone verwendet werden, Mit denen gute Bindungen zwischen dem Glasgewebe und dem Polyimid erzielt werden. Auf dem hergestellten Substrat werden die Solarzellen-Moduln und -Strings mit den entsprechenden Klebern aufgeklebt.

Der Erfindung liegt die Aufgabe zugrunde, ein Verfahren zur Herstellung eines flexiblen Trägersubstrates für einen photovoltaischen Solargenerator zu schaffen, der derart gegen atomaren Sauerstoff beständig ist, daß sein Missionsbereich vorzugsweise im Orbit mit atomaren Sauerstoffanteilen liegen kann.

Die Aufgabe wird bei einem Verfahren, bei dem eine auf einem heizbaren Laminiertisch befindliche Kaptonfolie mit einem Kleber beschichtet und ausgehärtet wird und auf die Kaptonfolie nach dem Auftrag einer Schicht zur Haftvermittlung ein Glasseidengewebe gelegt wird, das anschließend mit einem Silikonkleber getränkt wird, erfindungsgemäß durch folgende Verfahrensschritte gelöst:
a, während der Substratherstellung wird in den noch nicht ausgehärteten Silikonkleber ein Abreißgewebe eingebracht,
b, der Verbund aus Kaptonfolie, Glaseidengewebe und Abreißgewebe wird unter Vakuum ausgehärtet, und
c, vor einer Aufklebung von Solarzellen auf das flexible Trägersubstrat wird das Abreißgewebe derart abgezogen, daß eine aufgerissene Silikonstrukturoberfläche zur Aufklebung der Solarzellen entsteht.

Ein Vorteil der Erfindung besteht neben der Angabe eines einfachen und kostengünstigen Fertigungsverfahrens darin, daß die Solarzellen mit einem Silikonkleber auf die ausgehärtete Silikonfläche geklebt werden können, wobei der verwendete Silikonkleber gegen atomaren Sauerstoff beständig ist.

In einer Weiterbildung der Erfindung wird vorgeschlagen, daß das Abreißgewebe, das z. B. aus Nylon 6.6 bestehen kann, etwa 24 Stunden vor dem Aufkleben der Solarzellen abgezogen wird. Es kann auch ein Abreißgewebe Qualität 7849 der Fa. Steiger und Deschler verwendet werden. Der Verbund kann weiterhin unter einem Druck von 1 bar bei 140°C über 4 Stunden ausgehärtet werden. Als auf der Kaptonfolie auftragbarer Kleber kommt der DuPont Kleber Typ 46971 in Frage, während der Primerauftrag Typ 6790 bzw. DC 1200 und die Silikonkleber RTVS 691 bzw. DC 93500 verwendet werden können, wobei der Kleber RTVS 691 insbesondere auch zur Klebung der Solarzellen auf die ausgehärtete Silikonfläche herangezogen wird.

## Patentansprüche

1. Verfahren zur Herstellung eines flexiblen Trägersubstrates für einen photovoltaischen Solargenerator mit einer Vielzahl von auf einem aufrollbaren Substrat angeordneten photoelektrischen Solarzellen, wobei eine auf einem heizbaren Laminiertisch befindliche Kaptonfolie mit einem Kleber beschichtet und ausgehärtet wird, und auf die Kaptonfolie nach dem Auftrag einer Schicht zur Haftvermittlung ein Glasseidengewebe gelegt wird, das anschließend mit einem Silikonkleber getränkt wird, gekennzeichnet durch folgende Verfahrensschritte:
a) während der Substratherstellung wird in den noch nicht ausgehärteten Silikonkleber ein Abreißgewebe eingebracht,
b) der Verbund aus Kaptonfolie, Glasseidengewebe und Abreißgewebe wird unter Vakuum ausgehärtet, und
c) vor einer Aufklebung von Solarzellen auf das flexible Trägersubstrat wird das Abreißgewebe derart abgezogen, daß eine aufgerissene Silikonstrukturoberfläche zur Aufklebung der Solarzellen entsteht.

2. Verfahren nach Anspruch 1, dadurch gekennzeichnet, daß das Abreißgewebe etwa 24 Stunden vor dem Aufkleben der Solarzellen abgezogen wird.

3. Verfahren nach Anspruch 1, dadurch gekennzeichnet, daß der Verbund unter einem Druck von 1 bar bei 140°C über 4 Stunden ausgehärtet wird.

## Claims

1. Method for the production of a flexible carrier substrate for a photovoltaic solar generator with a plurality of photoelectric solar cells arranged on a substrate which can be rolled up, wherein a polyimide foil disposed on a heatable laminating table is coated with an adhesive and cured, and a glass silk cloth, which is subsequently impregnated with a silicone adhesive, is placed on the polyimide foil after the application of a coating for adhesive exchange, characterised by the following method steps:
a) a tear-off web is introduced into the still uncured silicone adhesive during the substrate production,
b) the composite of polyimide foil, glass silk cloth and tear-off web are cured under vacuum, and
c) before the gluing of solar cells onto the flexible carrier substrate the tear-off web is pulled off in such a manner that a torn up silicon structure surface arises for the gluing on of the solar cells.

2. Method according to claim 1, characterised thereby that the tear-off web is pulled off about 24 hours before the gluing on of the solar cells.

3. Method according to claim 1, characterised thereby that the composite is cured under a pressure of 1 bar at 140°C over four hours.

## Revendications

1. Procédé de production d'un substrat support souple destiné à un générateur solaire photovoltaïque comportant une pluralité de cellules solaires photoélectriques disposées sur un substrat enroulable, une feuille de polyimide se trouvant sur une table de laminage chauffante étant enduite d'une colle et durcie et un tissu de soie de verre qui est imbibé ultérieurement d'une colle silicone état placé sur la feuille de polyimide après dépôt d'une couche destinée à conférer l'adhésivité, caractérisé par les opérations de base suivantes :
a) pendant la fabrication du substrat, on incorpore un tissu d'arrachage à la colle silicone qui n'a pas encore durci,
b) le composite comprenant la feuille de polyimide, le tissu de soie de verre et le tissu d'arrachage est durci sous vide et
c) avant de coller les cellules solaires sur le substrat support souple, on retire le tissu d'arrachage de telle sorte qu'il se forme une surface à structure de silicone dénudée en vue du collage des cellules solaires.

2. Procédé selon la revendication 1, caractérisé en ce que le tissu d'arrachage est retiré environ 24 h avant le collage des cellules solaires.

3. Procédé selon la revendication 1, caractérisé en ce que le composite est durci sous une pression de 1 bar à 140°C pendant 4 h.
